# FASCICULE DE BREVET EUROPEEN

(11) **EP 3 080 334 B1**
(45) Date de publication et mention de la délivrance du brevet: **22.09.2021**
(21) Numéro de dépôt: 15706911.3
(22) Date de dépôt: 12.02.2015
(51) Int. Cl.: C23C 18/12, H01L 31/18

(54) **BAIN À MORPHOLINE ET PROCÉDÉ POUR LE DÉPÔT CHIMIQUE D'UNE COUCHE**
MORPHOLINBAD UND VERFAHREN ZUR CHEMISCHEN ABSCHEIDUNG EINER SCHICHT
MORPHOLINE BATH AND METHOD FOR CHEMICALLY DEPOSITING A LAYER

(30) Priorité: 12.12.2013 FR 1362539
(43) Date de publication de la demande: 19.10.2016
(73) Titulaire: Electricité de France, 75008 Paris (FR); Centre National de la Recherche Scientifique (C.N.R.S.), 75016 Paris (FR)
(72) Inventeur: HILDEBRANDT, Thibaud, F-75011 Paris (FR); NAGHAVI, Negar, F-75016 Paris (FR); LOONES, Nicolas, F-92000 Nanterre (FR); SCHNEIDER, Nathanëlle, F-75014 Paris (FR)
(74) Mandataire: Plasseraud IP
(86) Numéro de dépôt international: PCT/FR2015/050350
(87) Numéro de publication internationale: WO 2015/087022

(56) Documents cités:
- US-A1- 2013 084 401
- ASHISH K. SAHOO ET AL: "Controllable architecture of CdS and CuS by single-source precursor-mediated approach and their photocatalytic activity", JOURNAL OF NANOPARTICLE RESEARCH, vol. 15, no. 4, 28 mars 2013 (2013-03-28), XP055124346, ISSN: 1388-0764, DOI: 10.1007/s11051-013-1591-8
- AJAYI O B ET AL: "Preparation and characterization of MOCVD thin films of cadmium sulphide", THIN SOLID FILMS, ELSEVIER-SEQUOIA S.A. LAUSANNE, CH, vol. 248, no. 1, 1 août 1994 (1994-08-01), pages 57-62, XP024547542, ISSN: 0040-6090, DOI: 10.1016/0040-6090(94)90211-9 [extrait le 1994-08-01]
- KEVIN M. MCPEAK ET AL: "Chemical Bath Deposition of ZnO Nanowires at Near-Neutral pH Conditions without Hexamethylenetetramine (HMTA): Understanding the Role of HMTA in ZnO Nanowire Growth", LANGMUIR, vol. 27, no. 7, 5 avril 2011 (2011-04-05), pages 3672-3677, XP055124348, ISSN: 0743-7463, DOI: 10.1021/la105147u
- None

## Description

### DOMAINE TECHNIQUE

L'invention se rapporte au domaine des bains de dépôt chimique pour le dépôt de couches à base de soufre et de métal. Elle se rapporte également aux procédés de dépôt par voie chimique d'une couche à base de métal et de soufre,

### ARRIÈRE-PLAN TECHNOLOGIQUE

Les procédés de dépôt en bain chimique (CBD), ou Chemical Bath Deposition selon la terminologie anglo-saxonne, sont couramment utilisés dans l'industrie pour fabriquer, par exemple, des alliages en couches minces. Ces procédés sont particulièrement adaptés aux dépôts à grande échelle pour recouvrir de larges surfaces allant au-delà de 60 x 30 cm². Par ailleurs, cette technique est largement maîtrisée dans l'industrie du fait notamment de son faible coût et sa simplicité technique.

Un dépôt par voie chimique dans un bain peut à ce titre être envisagé dans la fabrication de certaines couches minces de dispositifs photosensibles. Plus particulièrement, les couches d'absorbeur que comprennent certains dispositifs photosensibles sont généralement recouvertes par une couche dite couche tampon réalisée en un alliage comprenant du métal et du soufre. Généralement, cette couche tampon se compose d'un alliage cadmium soufre CdS.

La toxicité du cadmium invite néanmoins à rechercher des matériaux alternatifs pour la couche tampon, tels que le sulfure de zinc ZnS et ses dérivés. Cependant, la vitesse de dépôt de ces alliages sur une surface quelconque et en particulier sur d'autres couches minces telles que des absorbeurs de lumière, n'est pas optimisée. L'obtention d'un dépôt par voie chimique conforme aux exigences de l'industrie peut ainsi impliquer des temps jugés longs, supérieurs à 15 minutes voire une heure. Un tel rallongement du temps de dépôt entraine un surcoût de fabrication et pénalise toute la chaîne de production d'un dispositif.

Pour cette raison, une attention particulière est portée à la recherche de moyens techniques permettant de réaliser le dépôt d'une couche à base au moins de soufre et d'un métal par CBD.

Afin de réduire les temps de dépôt d'une telle couche, il est connu d'augmenter soit la concentration des réactifs du bain chimique, soit sa température ou bien encore de préchauffer les réactifs. Ces trois moyens présentent néanmoins pour inconvénient d'entraîner une augmentation de la consommation de matière et d'énergie. Par ailleurs ils peuvent aussi présenter un risque de détérioration de la surface de dépôt, ou bien encore impliquer des étapes supplémentaires dans une chaîne de production de nature à engendrer un surcoût.

Une autre solution pour accélérer les vitesses de dépôt consiste à utiliser un précurseur de soufre particulier dans un bain chimique. Généralement, les bains chimiques pour le dépôt d'une couche de métal et de soufre font intervenir en guise de précurseur de soufre une solution de thio-urée. Le document US2013/0084401 propose de remplacer la thio-urée par de la thioacétamide. Cette alternative présente néanmoins le désavantage que la thioacétamide est un composé fortement toxique et donc peu adapté pour une application industrielle.

Une autre alternative suggérée dans le document DE102009015063A1 consiste à rajouter du péroxyde d'hydrogène H₂O₂ dans un bain chimique prévu pour le dépôt d'une couche mince à base de soufre et de métal. Cette solution n'est pas adaptée aux applications industrielles dans lesquelles la surface de dépôt est fragile, étant donnée la nature corrosive de l'additif H₂O₂.

Pour ces raisons, il est recherché un moyen permettant d'augmenter la vitesse de dépôt en bain chimique d'une couche comprenant au moins du soufre et un métal et qui soit compatible avec une vaste gamme d'applications industrielles.

### EXPOSE DE L'INVENTION

Pour répondre aux problèmes exposés ci-avant, la présente invention propose un bain chimique pour le dépôt d'une couche à base au moins de métal et de soufre. Ce bain comprend en solution :
- un sel métallique comportant un métal choisi parmi au moins un des éléments des groupes IIB et IIIA du tableau périodique ; et
- un précurseur de soufre, qui est une solution de thiourée CS(NH₂)₂.

Ce bain comporte en outre un composé de type morpholine.

Un bain pour le dépôt chimique d'une couche comprenant du soufre et un métal issu des groupes IIB ou IIIA du tableau périodique est ainsi optimisé en rajoutant dans le mélange en solution du bain un additif organique non toxique de type morpholine. Le demandeur a constaté que l'ajout de morpholine produit dans le mélange un effet comparable à celui d'un accélérateur de réaction. En effet, la morpholine semble interagir avec le précurseur de soufre en favorisant son hydrolyse, à l'instar d'une solution de pH basique comme de l'ammoniaque. De cette manière, la présence de morpholine peut permettre d'accélérer la formation de l'alliage à base de soufre et de métal sur la surface de dépôt. La morpholine est un composé organique présentant à la fois une fonction amine, conférée par la présence d'un groupement -NH (fonction amine), et une fonction éther (-O-). La combinaison de ces deux fonctions peut agir sur les ions de sel métallique, par exemple du Zn²⁺, en favorisant leur intégration dans des complexes. Ces complexes interviennent dans la réaction permettant de déposer le métal et le soufre en une même couche. Ainsi, la morpholine intervient dans le bain en tant qu'agent complexant.

L'augmentation de la vitesse de dépôt est un effet qui semble particulièrement marqué lorsque le métal appartient aux groupes IIB ou IIIA, comme par exemple le zinc Zn ou l'indium In.

Par ailleurs, outre l'augmentation de la vitesse de dépôt, le demandeur a constaté que l'ajout de morpholine permet d'obtenir des couches à base de métal et de soufre homogènes sur de larges surfaces. L'ajout de morpholine dans le bain chimique permet ainsi d'obtenir un dépôt homogène sur une grande surface par rapport à des dépôts CBD faisant intervenir des bains dépourvus de cet additif.

Un autre effet avantageux conféré par l'ajout de morpholine réside dans le fait que le dépôt peut être envisagé sans préchauffage des réactifs du bain. En éliminant une étape antérieure de préchauffage, il est possible d'augmenter la vitesse de production à échelle industrielle. Cependant, un préchauffage des réactifs peut également être envisagé, de sorte que le bain décrit ci-avant peut aisément être préparé dans des chaînes de production préexistantes.

L'ajout de morpholine dans un bain de dépôt par voie chimique présente par ailleurs l'avantage qu'il confère au mélange réactionnel du bain un pH basique. Grâce à une constante d'acidité pKa de valeur 8,5, la morpholine peut être envisagée dans un bain dépourvu d'une solution d'ammoniaque. En effet, l'ammoniaque qui se retrouve généralement dans les bains de dépôt CBD a pour fonction d'augmenter le pH d'un mélange réactionnel pour favoriser l'hydrolyse des composés. Cette même fonction peut avantageusement être remplie par la morpholine, permettant ainsi de réaliser des économies de réactifs lors de la préparation du bain.

Ces différents effets sont indépendants de la surface sur laquelle le dépôt est effectué. En particulier, le bain optimisé décrit ci-avant permet par exemple d'effectuer des dépôts sur du verre, des substrats métalliques ou semi-conducteurs ainsi que sur des composés à propriétés photovoltaïques tels que des absorbeurs.

De même ces effets ont été observés dans différentes configurations expérimentales et semblent se manifester indépendamment de la concentration des réactifs du bain chimique. Il est cependant avantageusement préféré une température inférieure au seuil de dénaturation de l'un des composés du mélange réactionnel.

Selon un mode de réalisation, le composé de type morpholine a une fonction amine et une fonction éther agissant dans le bain en tant qu'agent complexant.

Les fonctions éther et amines de la morpholine sont des groupements actifs dans le composé de type morpholine utilisés dans le bain. Ces fonctions contribuent à déposer en une même couche le métal et le soufre en formant des complexes avec les ions métalliques issus des autres réactifs du bain, comme expliqué ci-avant.

Selon un mode de réalisation avantageux, le composé peut être de formule chimique C₄H₉NO.

Ce composé peut avantageusement se présenter dans une solution miscible avec les autres réactifs du bain chimique. Il a été remarqué que le composé morpholine de formule chimique C₄H₉NO optimise de manière particulièrement visible la vitesse de dépôt et l'homogénéité de la couche obtenue. Cependant, le principe actif de la morpholine se retrouve également dans une large gamme de molécules dérivées, comprenant en outre une fonction éther et une fonction amine. Par conséquent d'autres composés à base de morpholine pourraient être envisagés.

Selon un mode de réalisation, une concentration comprise entre 0,001 mol/L et 10 mol/L de morpholine peut être prévue dans le bain, pour une concentration comprise entre 0,05 mol/L et 1 mol/L du composé sulfuré,

Un tel mélange réactionnel dans le bain correspond à un compromis entre quantité de réactifs utilisés et rapidité du dépôt. En effet, en s'efforçant de maintenir une faible quantité d'additif et de composé sulfuré, il est possible de réaliser des économies substantielles lors d'une production à échelle industrielle. Ceci passe notamment par une réduction du gaspillage des réactifs.

Avantageusement, la solution contenant le sel métallique peut être une solution choisie parmi : le sulfate de zinc, l'acétate de zinc et le chlorure de zinc avec une concentration comprise entre 0,01 mol/L et 1 mol/L.

Le sel métallique peut comprendre d'autres métaux issus des groupes IIB et IIIA du tableau périodique. Cependant, un sel métallique de zinc dans le bain a permis d'obtenir une réduction particulièrement marquée du temps de dépôt. En effet, par rapport à un dépôt CBD dans un bain dépourvu de morpholine faisant intervenir un sel métallique de zinc, l'invention permet d'atteindre une vitesse de dépôt pouvant être jusqu'à quatre fois plus élevée.

Une concentration comprise entre 0,01 mol/L et 1 mol/L de sel métallique permet notamment de réduire la quantité de matière première utilisée pour déposer la couche.

Selon un mode de réalisation, le bain peut comprendre en outre une solution d'ammoniaque avec une concentration inférieure à 10 mol/L

L'emploi d'une solution d'ammoniaque permet de conférer un pH basique au bain chimique, de manière à amorcer une hydrolyse du précurseur de soufre en vue de le faire réagir avec le sel métallique.

Selon un mode de réalisation, le bain peut être dépourvu de solution d'ammoniaque.

Etant donné le caractère naturellement basique de la morpholine en solution, il est possible de ne pas ajouter d'ammoniaque au bain chimique. De cette manière, l'invention permet de réaliser des économies de réactifs lors de la préparation du bain. Il s'avère que la morpholine constitue un substitut efficace à l'ammoniaque, malgré une constante d'acidité pKa de valeur 8,5, soit une valeur inférieure de 0,75 à la constante d'acidité de l'ammoniaque.

Selon la présente invention, la solution contenant le composé sulfuré est une solution de thio-urée CS(NH₂)₂.

La thio-urée est un précurseur de soufre particulièrement adapté pour le dépôt de couches comprenant du sulfure. Il s'emploie couramment dans l'industrie des dispositifs photosensibles par exemple.

Par ailleurs, la thio-urée permet un dépôt particulièrement rapide en présence de morpholine et d'un sel métallique. Les vitesses de dépôt obtenues lorsque de la thio-urée est utilisée peuvent ainsi être inférieures à 5 minutes pour une couche de sulfure ou oxysulfure de métal de 20 nm d'épaisseur.

Plus particulièrement, le métal peut être un élément de la colonne IIB.

Les métaux de la colonne IIB présentent un intérêt particulier pour l'industrie des dispositifs photosensibles. Dans ces dispositifs, les métaux tels que le cadmium ou le zinc peuvent être présents dans la couche tampon entre l'absorbeur et le contact électrique avant d'une cellule photosensible. Les éléments de la colonne IIB sont donc particulièrement adaptés pour un bain chimique destiné à la réalisation de couches tampons.

Selon un mode de réalisation particulier, le métal peut être du zinc.

Le dépôt par CBD d'une couche de sulfure ou oxysulfure de zinc présente un intérêt par exemple dans l'industrie des dispositifs photosensibles de par ses propriétés optiques et sa non-toxicité, En effet, une couche réalisée en un tel alliage constitue une alternative efficace et non toxique aux couches tampon de CdS, tout en permettant de transmettre plus de rayonnement de longueur d'onde inférieure à 500 nm.

Une couche de sulfure ou oxysulfure de zinc présente une bande interdite de plus grande énergie qu'une couche en CdS, permettant ainsi de transmettre plus de lumière de longueur d'onde inférieure à 500 nm qu'une couche en CdS. Par ailleurs, une couche de sulfure ou oxysulfure de zinc présente des propriétés optiques de transmission équivalentes à celles de couches en oxyde de zinc ZnO, souvent utilisées pour constituer des contacts électriques avant dans des dispositifs photosensibles.

L'invention se rapporte également à un procédé de dépôt par voie chimique d'une couche à base au moins de métal et de soufre, dans un bain comprenant en solution :
- un sel métallique comportant un métal choisi parmi au moins un des éléments des groupes IIB et IIIA du tableau périodique ; et
- un précurseur de soufre, qui est une solution de thiourée CS(NH2)2.

En outre, un composé de type morpholine est prévu dans le bain.

Le dépôt d'une couche à base au moins de métal et de soufre par CBD en ajoutant de la morpholine dans le bain chimique offre plusieurs avantages, décrits ci-avant. L'ajout de morpholine dans le bain augmente la vitesse du dépôt, permet d'aboutir à des couches plus homogènes, et permet d'envisager un gain de temps de préparation par la suppression éventuelle d'une étape antérieure de préchauffage des réactifs du bain chimique.

Dans un mode particulier de réalisation, la couche peut être à base de sulfure de métal.

Le sulfure de métal, par exemple ZnS, peut être un alliage particulièrement adapté pour des applications dans les dispositifs photosensibles. Par exemple, il peut s'employer comme couche tampon sur des absorbeurs de dispositifs photosensibles.

Dans un autre mode de réalisation, la couche peut être à base d'oxysulfure de métal.

Les oxysulfures de métal, comme par exemple Zn(S,O), Zn(S,O,OH) ou Inₓ(S,O)_{y}, Inₓ(S,O,OH)_{y}, avec 0<x<2 et 0<y<3, peuvent présenter des propriétés optiques particulièrement adaptées aux besoins de l'industrie des dispositifs photosensibles. Ils peuvent également être adaptés pour une utilisation en tant que couches tampons sur une couche photosensible.

De manière avantageuse, la température du bain lors du dépôt peut être comprise entre 40°C et 100°C.

Une température de dépôt inférieure à 100°C et notamment inférieure à 70°C permet d'envisager un environnement de travail moins dommageable pour des dispositifs comprenant des alliages à faible température de fusion, sans être pénalisé par une augmentation de la durée du dépôt. Par ailleurs, en réduisant la température du milieu réactionnel, il est possible de réaliser des économies d'énergie en chauffant moins un bain de dépôt CBD. L'économie est d'autant plus important que la taille du bain est grande, cette taille pouvant atteindre dans l'industrie plusieurs mètres carrés.

Selon un mode de réalisation, la couche à base de métal et de soufre peut être déposée sur une couche à propriétés photovoltaïques, ladite couche à propriétés photovoltaïques formant absorbeur de cellule solaire en couches minces.

De cette manière, la couche à base de métal et de soufre peut représenter une couche tampon, déposée sur un absorbeur de cellule photovoltaïque en couches minces, permettant d'interfacer l'absorbeur avec un contact électrique avant. La qualité de la jonction entre l'absorbeur d'une cellule photosensible et la couche tampon est cruciale pour atteindre un rendement de conversion élevé dans le dispositif obtenu. L'application du procédé de dépôt chimique décrit ci-avant pour le dépôt d'une couche tampon sur un absorbeur permet d'obtenir des couches homogènes présentant moitié moins de défauts que des couches tampons déposées dans un bain dépourvu de morpholine, déposées en un temps inférieur à 10 minutes et sans endommager l'absorbeur lui-même.

De par la qualité de la couche tampon obtenue par la mise en œuvre du procédé, le dispositif photovoltaïque qui en résulte peut posséder un rendement de conversion supérieur à 14%.

Il est à noter que l'utilisation de la morpholine comme additif dans un bain chimique pour le dépôt d'une couche tampon sur un absorbeur de cellule photovoltaïque est contre-intuitive. En effet, la morpholine est généralement utilisée dans l'industrie du caoutchouc ou pour la synthèse de médicaments et de produits phytosanitaires.

Notamment, l'absorbeur peut être à base d'un composé chalcopyrite parmi Cu(In, Ga)(S,Se)₂, Cu₂(Zn,Sn)(S,Se)₄ et leurs dérivés.

Ces composés peuvent par exemple comprendre le Cu(In,Ga)Se₂, CuInSe₂, CuInS₂, CuGaSe₂, Cu₂(Zn,Sn)S₄ et le Cu₂(Zn,Sn)Se₄. Lorsque ces absorbeurs contiennent du zinc et de l'étain, ils sont parfois nommés CZTS.

Les absorbeurs de cellules solaires listés ci-dessus correspondent aux absorbeurs de cellules en couches minces de type CIGS, CZTS et leurs dérivés présentant des rendements de conversion pouvant être supérieurs à 20%. La mise en œuvre du procédé décrit ci-avant pour le dépôt d'une couche tampon sur ces absorbeurs s'avère particulièrement avantageuse étant donné les gains en performance qu'elle permet d'obtenir. Par exemple, en déposant ainsi une couche tampon de ZnS, Zn(S,O) ou Zn(S,O,OH) sur un absorbeur à base d'un composé chalcopyrite, il est possible d'obtenir un rendement de conversion supérieur à 14%, une tension en circuit ouvert et un courant en court-circuit du dispositif final supérieurs à ceux observés dans des dispositifs obtenus par d'autres procédés de dépôt.

### DESCRIPTIF DES FIGURES

Le procédé objet de l'invention sera mieux compris à la lecture de la description qui suit d'exemples de réalisations présentés à titre illustratif, aucunement limitatifs, et à l'observation des dessins ci-après sur lesquels :
- la figure 1 est une représentation schématique d'un échantillon destiné à recevoir le dépôt d'une couche de métal et de soufre; et
- la figure 2 est une représentation schématique du mode opératoire de préparation d'un bain chimique; et
- la figure 3 est un graphique comparant les temps de dépôts mesurés pour obtenir différentes épaisseurs de couches suivant trois procédés différents; et
- la figure 4 est une représentation schématique d'un dispositif photosensible; et
- la figure 5 est un graphique comparant les efficacités quantiques de deux couches réalisées en des matériaux différents en fonction de la longueur d'onde reçue.

Pour des raisons de clarté, les dimensions des différents éléments représentés sur ces figures ne sont pas nécessairement en proportion avec leurs dimensions réelles. Sur les figures, des références identiques correspondent à des éléments identiques.

### DESCRIPTION DÉTAILLÉE

L'invention se rapporte à un bain de dépôt chimique et à un procédé de dépôt CBD améliorés. L'amélioration vise en particulier à augmenter de manière significative la vitesse de dépôt. D'autres effets avantageux ont également été obtenus dans le cadre de l'invention, comme par exemple une qualité de dépôt accrue.

Dans les modes de réalisation donnés à titre d'exemple ci-après, il sera décrit le cas particulier du dépôt par CBD d'une couche tampon sur un absorbeur de cellule photovoltaïque. Cependant, l'invention peut également s'appliquer à un dépôt sur tout autre type de surface, comme il sera rappelé plus loin.

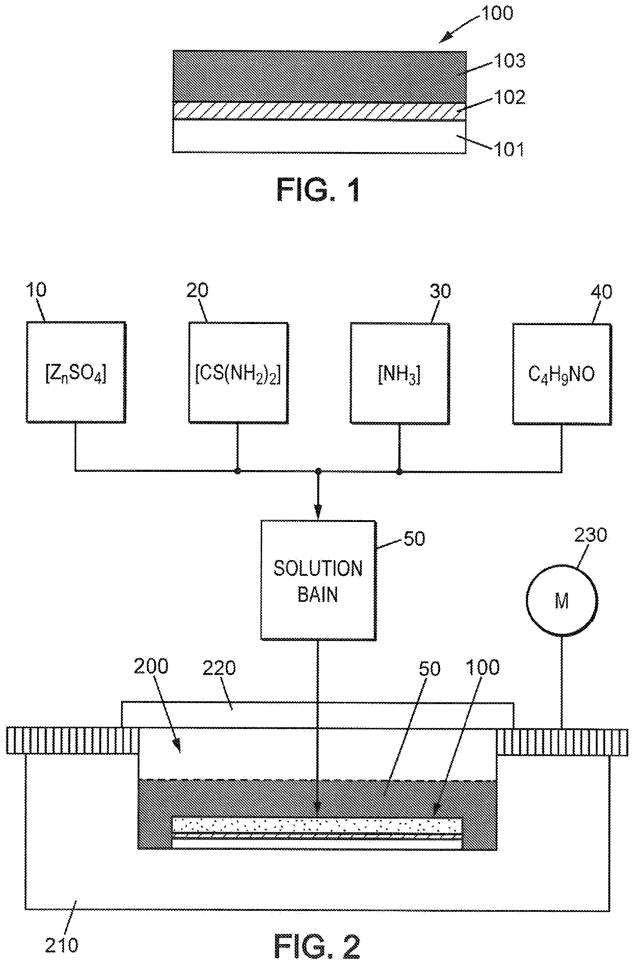

Dans le contexte du dépôt d'une couche mince comprenant au moins du soufre et un métal, la figure 1 illustre un exemple d'échantillon initial 100, comprenant un substrat 101, un contact métallique arrière 102 et une couche d'absorbeur 103. L'échantillon initial 100 illustré représente ainsi une portion non terminée d'un dispositif photosensible à couches minces. À titre d'exemple, l'absorbeur 103 destiné à convertir du rayonnement en courant peut être un composé de type chalcopyrite tel que l'un des composés parmi Cu(In,Ga)(S,Se)₂, Cu₂(Zn,Sn)(S,Se)₄ et leurs dérivés. Ces dérivés peuvent par exemple comprendre Cu(In,Ga)Se₂, CuInSe₂, CuInS₂, CuGaSe₂, Cu₂(Zn,Sn)S₄ ou Cu₂(Zn,Sn)Se₄, plus communément nommés CIGS et CZTS.

En vue de terminer la fabrication de ce dispositif photosensible, l'invention propose une enceinte 200 pour bain chimique représentée schématiquement sur la figure 2. Comme dans la plupart des bains chimiques pour des dépôts CBD, l'enceinte 200 peut être fermée par un couvercle 220. Cette enceinte 200 contient une solution 50 constituée d'un mélange de réactifs dans des concentrations choisies. L'échantillon 100 repose dans cette solution 50. Des moyens de chauffage de ce milieu réactionnel peuvent être prévus. Sur la figure 2, un tel moyen est représenté par un bain marie 210 entourant l'enceinte du milieu réactionnel. Un moteur 230 peut également servir à actionner un mécanisme d'agitation permettant de brasser la solution 50.

La figure 2 illustre également de manière sommaire les étapes permettant d'obtenir la solution formant le mélange réactionnel 50.

Dans l'exemple illustré sur la figure 2, le bain chimique est configuré pour le dépôt d'une couche tampon d'un dispositif photovoltaïque, Pour cette raison, il est préparé à partir d'une première solution aqueuse comprenant un sel métallique 10, représentée comme étant du sulfate de zinc ZnSO₄. Une seconde solution aqueuse comprenant un précurseur de soufre 20 est également prévue. Cette seconde solution est représentée comme étant de la thio-urée, de formule chimique CS(NH₂)₂. De l'ammoniaque 30, permettant de conférer un pH basique au mélange réactionnel peut également être prévu à titre optionnel. Un milieu basique dû à la présence d'ammoniaque peut favoriser la réaction du précurseur avec le sel métallique. Finalement, une quatrième solution aqueuse comprenant un additif organique 40 à base de morpholine est préparée. Cette quatrième solution 40 est représentée comme comprenant de la morpholine de formule chimique C₄H₉NO.

Des alternatives aux trois premières solutions peuvent être envisagées, comme il sera décrit plus loin.

Ces quatre solutions 10, 20, 30, 40, sont ensuite mélangées afin de créer un mélange réactionnel 50. Ce mélange réactionnel 50 constitue la solution dans laquelle trempe l'échantillon 100.

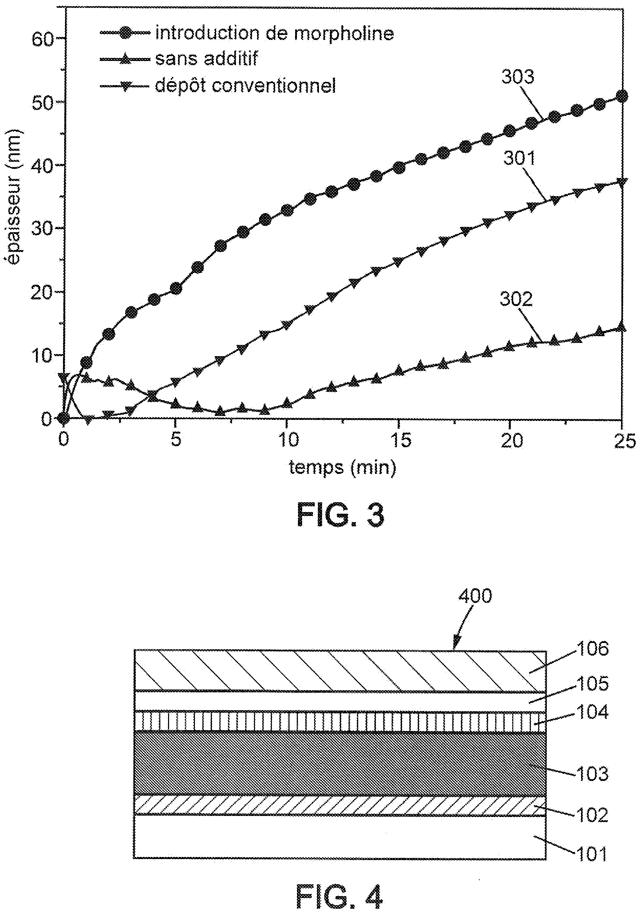

De manière avantageuse, l'ajout de morpholine réduit considérablement la durée nécessaire pour réaliser un dépôt de ZnS sur l'absorbeur. Pour illustrer le gain en temps réalisé, le diagramme de la figure 3 compare les vitesses de dépôt par CBD d'une couche mince, mesurées dans trois conditions différentes.

La couche de ZnS déposée peut comprendre de l'oxygène et former une couche de type Zn(S,O) ou Zn(S,O,OH). Il sera ci-après fait référence à une couche de ZnS pour désigner aussi bien une couche pure de ZnS qu'une couche de Zn(S,O) ou Zn(S,O,OH).

La courbe 301 montre le temps nécessaire pour déposer des couches de ZnS de différentes épaisseurs, lorsque le mélange réactionnel 50 se trouve dans une configuration conventionnelle. Il est entendu par conventionnelle une concentration en thio-urée de 0,65 mol/L, une concentration en ZnSO₄ de 0,15 mol/L une concentration d'ammoniaque de 2 mol/L. Les réactifs ont tous été préchauffés à une température de 80°C, avant d'être déposés dans une enceinte portée à la même température de 80°C.

La courbe 302 représente le temps nécessaire pour déposer des couches de ZnS de différentes épaisseurs, lorsque le mélange réactionnel 50 comprend une configuration testée en laboratoire et correspondant à un mode de réalisation particulièrement avantageux. Il se caractérise par une concentration en thio-urée de 0,4 mol/L, une concentration en ZnSO₄ de 0,1 mol/L une concentration en ammoniaque de 2 mol/L. Aucun préchauffage des réactifs n'est prévu et la température du dépôt est de 70°C.

La courbe 303 représente le temps nécessaire pour déposer des couches de ZnS de différentes épaisseurs, lorsque le mélange réactionnel 50 comprend les mêmes caractéristiques que celles associées à la courbe 302, mais avec l'ajout d'une concentration de 2,2 mol/L de morpholine. Le tableau 1 ci-dessous résume les trois configurations décrites ci-avant.

**Tableau 1 : récapitulatif des trois configurations de dépôt représentées à la figure 3**

| Couche ZnS | Thio-urée (mol/L) | ZnSO₄ (mol/L) | NH₃ (mol/L) | C₄H₉NO (mol/L) | T dépôt (°C) |
|---|---|---|---|---|---|
| Dépôt conventionnel | 0,65 | 0,15 | 2 | | 80 |
| Avec additif | 0,4 | 0,1 | 2 | 2,2 | 70 |
| Sans additif | 0,4 | 0,1 | 2 | | 70 |

Il apparaît, d'après l'évolution des trois courbes 301, 302 et 303 de la figure 3, que l'ajout de C₄H₉NO dans un bain chimique augmente considérablement la vitesse de dépôt d'une couche de ZnS. Notamment, pour obtenir une couche de 20 nm d'épaisseur, le bain optimisé selon l'invention divise par 2,5 le temps de dépôt par rapport à des techniques conventionnelles, et par plus de 5 par rapport à un dépôt réalisé dans les mêmes conditions sans l'additif organique.

Par ailleurs, il convient de remarquer que les conditions de dépôt dans le bain chimique du demandeur sont plus économes en matière première et énergie. Ceci résulte de concentrations moindres en réactifs, d'une température de dépôt plus petite et de l'absence d'un préchauffage des réactifs.

L'exemple décrit ci-avant peut avantageusement donner lieu à la réalisation d'un dispositif photovoltaïque complet tel que représenté sur la figure 4.

La figure 4 illustre schématiquement une cellule solaire en couches minces comprenant les mêmes éléments structuraux que ceux de la figure 1. Le dispositif 400 représenté comprend en outre une couche tampon 104 déposée par CBD sur l'absorbeur, comme décrit précédemment. Par-dessus la couche tampon 104 une première couche fenêtre 105, par exemple en oxyde de zinc intrinsèque ou en ZnMgO, peut être déposée par des techniques connues comme la pulvérisation réactive, un dépôt chimique en phase vapeur, un électrodépôt, un dépôt CBD ou un dépôt ILGAR®. Un contact électrique avant 106 peut ensuite être déposé. Il peut par exemple s'agir d'une couche en oxyde de zinc ZnO dopé aluminium.

D'autres avantages propres à l'utilisation du bain chimique décrit ci-avant pour déposer une couche tampon se reflètent dans les performances des dispositifs photovoltaïques obtenus.

Le tableau 2 compare des caractéristiques techniques de cellules solaires telles que la cellule solaire de la figure 4, comprenant un absorbeur de type chalcopyrite CIGS. Une première cellule comprend une couche tampon ZnS obtenue dans les conditions de dépôt conventionnelles décrites ci-avant en relation avec la courbe 301 de la figure 3. Une seconde cellule comprend une couche tampon ZnS obtenue par un procédé de dépôt CBD faisant intervenir le bain objet de l'invention, dans des conditions identiques à celles décrites en relation avec la courbe 303 de la figure 3. Une troisième cellule comprend une couche tampon CdS obtenue par CBD dans des conditions de dépôt conventionnelles.

**Tableau 2 : Comparaison des performances de trois cellules solaires.**

| **Couche tampon** | **Rendement (%)** | **Facteur de forme (%)** | **Voc (mV)** | **Jsc (mA/cm²)** |
|---|---|---|---|---|
| **ZnS CBD conventionnelle** | **13,7** | **71,8** | **611** | **31,3** |
| *Ecart type* | *+*/*- 0,41* | *+*/*- 1,9* | +/- *3,3* | +/- *0,52* |
| **ZnS CBD avec additif** | **14,4** | **74,6** | **622** | **30,8** |
| *Ecart type* | +/- *0,18* | +/- *0,46* | +/- *2* | +/- *0,18* |
| **CdS CBD conventionnelle** | **13,8** | **73,7** | **619** | **30,1** |
| *Ecart type* | +/- *0,13* | +/- *0,36* | +/- *4,6* | *+*/*- 0,15* |

Chaque cellule du tableau 2 possède une surface de 5x5 cm², et une couche tampon de 20 nm d'épaisseur.

Les colonnes du tableau 2 représentent quatre paramètres pour chacune des trois cellules solaires. La première colonne représente le rendement de conversion de la cellule solaire. La seconde colonne représente le facteur de forme de chaque cellule, fournissant une indication sur la qualité de la jonction entre couche tampon et absorbeur. La troisième colonne représente une tension de circuit ouvert Voc. Plus cette tension est élevée, meilleure est la cellule sur le plan électrique. La quatrième colonne représente le courant de court-circuit Jsc. Plus ce courant est élevé, meilleure est la cellule sur le plan électrique.

Par ailleurs, pour chaque cellule du tableau 2, et pour chaque paramètre, un écart type de la valeur correspondante est indiqué. Cette information permet de fournir une estimation de l'homogénéité de la cellule. En effet, plus un paramètre varie au sein même de la cellule, plus l'écart type associé est élevé. Une telle instabilité est indicatrice de défauts structurels dans la cellule, et a fortiori dans la couche tampon qui est la seule couche présentant des différences substantielles entre les trois cellules comparées

Il ressort des valeurs du tableau 2 que la cellule possédant une couche tampon ZnS réalisée par le procédé de dépôt CBD mis au point dans le cadre de l'invention présente une homogénéité supérieure aux autres cellules. Elle présente notamment une homogénéité plus élevée que celle de la cellule possédant une couche ZnS réalisée par un dépôt CBD conventionnel.

Par ailleurs la cellule réalisée par le procédé de l'invention présente un rendement de conversion supérieur à celui des autres cellules ainsi que de meilleures propriétés électriques.

Le facteur de forme de la cellule obtenue par le procédé de l'invention est comparable à celui de cellules à couche tampon en CdS. Néanmoins, l'homogénéité globale de la cellule réalisée grâce au dépôt CBD avec addition de morpholine est meilleure. Par conséquent le procédé de dépôt avec addition de morpholine peut être bien adapté à la réalisation de cellules photosensibles de large surface, ou plus généralement, pour la réalisation de couches comprenant du métal et du soufre en milieu industriel.

Une observation au microscope électronique a permis de confirmer ces observations sur la qualité structurelle du dépôt obtenu par la mise en œuvre du procédé de l'invention

Le bain chimique développé et le procédé qui l'utilise pour réaliser une couche tampon, permettent d'obtenir dans des conditions de dépôt adaptées une couche tampon en un matériau non toxique, par exemple dépourvu de cadmium.

Les propriétés électriques et optiques améliorées des couches tampon de sulfures et oxysulfures de zinc ont été étudiées par le calcul de l'efficacité quantique de la couche, comparée à celle d'une couche tampon de CdS.

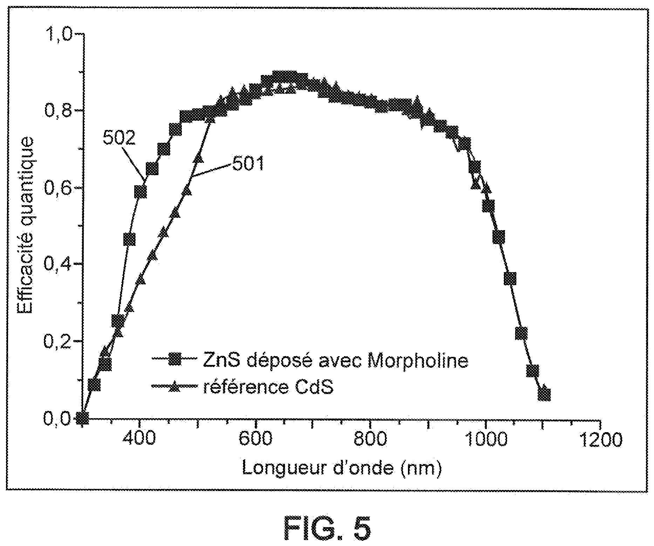

La figure 5 représente un diagramme comparant l'efficacité quantique entre 300 nm et 1100 nm d'une couche tampons ZnS, représentée par la courbe 502 avec celle d'une couche tampon CdS, représentée par la courbe 501. L'efficacité quantique est un paramètre qui traduit le rapport entre la quantité d'électrons produits et la quantité de photons reçus par le dispositif photosensible.

Il apparaît sur la figure 5 qu'une couche tampon en ZnS permet d'aboutir à une meilleure conversion de lumière aux longueurs d'onde inférieures à 500 nm. Ce gain en courant peut s'expliquer par un plus grand coefficient de transmission de la lumière dans du ZnS à ces longueurs d'onde comparé au CdS. Cette propriété optique est elle-même issue de la structure de bande du matériau, qui possède une bande interdite électronique de plus grande valeur en énergie que le CdS.

La présente invention ne se limite pas aux formes de réalisation décrites ci-avant à titre d'exemple; elle s'étend également à d'autres variantes. En effet, le bain décrit ci-avant et le procédé utilisant ce bain pour réaliser une couche mince comprenant du métal et du soufre peuvent se décliner dans différentes configurations bénéficiant toutes du gain de vitesse de dépôt et de la qualité de couche obtenue décrits ci-avant.

Ainsi, les concentrations des différents constituants du mélange réactionnel 50 sont ajustables. Dans un souci d'économie, il est préférable de réduire la concentration des réactifs. Cependant, une réduction des concentrations tend à augmenter la durée nécessaire pour produire une couche mince d'une épaisseur donnée. Les exemples décrits ci-avant correspondent à un compromis entre concentration et vitesse de réaction. Il est possible de prévoir d'autres concentrations et d'autres températures en vue de répondre à un besoin différent. Il peut par exemple être intéressant d'ajuster les concentrations et températures pour déposer avec une contrainte de temps fixée une épaisseur donnée de couche mince. En effet, du fait d'une vitesse de dépôt globalement accrue, il est envisageable d'utiliser le dépôt CBD employant de la morpholine en guise d'additif pour réaliser en un temps raisonnable, par exemple inférieur à une heure, des couches de plus de 150 nm d'épaisseur.

En augmentant la vitesse du dépôt, il est possible de prévoir une faible température du mélange réactionnel. Par rapport à des techniques conventionnelles de dépôt impliquant généralement des températures d'environ 70°C, l'invention permet d'obtenir un dépôt de durée inférieure à 15 minutes même lorsque la température descend en-dessous de 60°C, par exemple jusqu'à 40°C.

Le compromis entre vitesse de dépôt et concentration des réactifs peut être considéré comme satisfait pour une concentration en sel métallique comprise entre 0,01 mol/L et 1 mol/L, une concentration en précurseur de soufre comprise entre 0,05 mol/L et 1 mol/L, une concentration en morpholine comprise entre 0,001 mol/L et 10 mol/L et une concentration en ammoniaque comprise entre 0,1 mol/L et 10 mol/L,

D'autre part, le bain et le procédé qui l'utilise peuvent être envisagés sans prévoir l'ajout d'ammoniaque. Il est par exemple envisageable soit de le substituer par un autre composé à pH basique, ou un composé de pKa supérieur à 7, soit de le supprimer du bain. En supprimant ce réactif, le procédé de dépôt CBD devient encore moins coûteux à mettre en œuvre, sans impacter de manière négative la vitesse ou la qualité du dépôt.

A minima, le mélange réactionnel du bain chimique peut ne comporter que de la morpholine, le précurseur de soufre et un sel métallique. À partir de ces constituants de base, la composition du mélange réactionnel peut différer de celle décrite en détail ci-avant.

Notamment, il est envisageable d'utiliser d'autres composés à base de morpholine, comprenant des groupements fonctionnels plus ou moins longs. Avantageusement, ce composé confère à la solution un pH basique permettant d'assurer l'hydrolyse du précurseur de soufre.

Outre le sulfate de zinc, le sel métallique peut être remplacé par l'acétate ou le chlorure de zinc pour les mêmes applications que celles décrites ci-avant. L'acétate de zinc peut être anhydre ou hydraté, par exemple de formule Zn[CH₃COOH]₂. Par ailleurs, en guise de sel métallique, un sel à base d'indium ou de cadmium peuvent également convenir pour réaliser des couches tampons sur des dispositifs photosensibles.

Par ailleurs, le dépôt d'une couche de soufre et de zinc s'effectuant en milieu aqueux, il peut y avoir une incorporation d'oxygène dans les couches déposées formant un oxysulfure de zinc de type Zn(S,O) ou Zn(S,O,OH). De même, il est possible d'incorporer de l'oxygène dans une couche comprenant un autre élément métallique, comme l'indium, pour former un oxysulfure d'indium de type Inₓ(S,O)_{y} ou Inₓ(S,O,OH)_{y}. Toutefois, les autres éléments des groupes IIB et IIIA du tableau périodique peuvent également être envisagés en guise de métal, du fait de leurs propriétés chimiques similaires à celles du zinc, indium ou cadmium.

Comme évoqué précédemment, il est possible d'appliquer le procédé décrit ci-avant dans d'autres contextes que le dépôt d'une couche tampon sur un absorbeur de cellule photosensible. En effet, l'invention a également été testée avec succès sur d'autres surfaces de dépôt comme du verre, un substrat semi-conducteur et un métal.

Plus généralement, l'invention décrite ci-avant optimise un bain chimique pour le dépôt d'une couche mince comprenant du soufre et un métal. Cette optimisation augmente la vitesse du dépôt, tout en améliorant la qualité structurelle de la couche obtenue, et permet d'envisager des économies de matière et énergie. Par ailleurs, l'invention présente l'avantage d'être compatible avec les bains chimiques pour dépôt chimiques CBD existants, et offre une solution avantageuse pour des dépôts CBD à échelle industrielle sur de grandes surfaces.

## Revendications

1. Bain chimique pour le dépôt d'une couche (104) à base au moins de métal et de soufre, le bain comprenant en solution (50) :
- un sel métallique (10) comportant un métal choisi parmi au moins un des éléments des groupes IIB et IIIA du tableau périodique ; et
- un précurseur de soufre (20) ;
**caractérisé en ce que** le bain comporte en outre un composé de type morpholine (40) et **en ce que** le précurseur de soufre (20) est une solution de thio-urée CS(NH₂)₂.

2. Bain selon l'une quelconque des revendications précédentes, **caractérisé en ce que** le composé (40) est de formule chimique C₄H₉NO.

3. Bain selon l'une quelconque des revendications précédentes, **caractérisé en ce qu'**une concentration comprise entre 0,001 mol/L et 10 mol/L de morpholine (40) est prévue dans le bain, pour une concentration comprise entre 0,05 mol/L et 1 mol/L du composé sulfuré (20).

4. Bain selon la revendication 3, **caractérisé en ce que** la solution contenant le sel métallique (10) est une solution choisie parmi : le sulfate de zinc, l'acétate de zinc et le chlorure de zinc avec une concentration comprise entre 0,01 mol/L et 1 mol/L.

5. Bain selon l'une quelconque des revendications 3 et 4, **caractérisé en ce qu'**il comprend en outre une solution d'ammoniaque (30) avec une concentration inférieure à 10 mol/L.

6. Bain selon l'une quelconque des revendications 1 à 4, **caractérisé en ce qu'**il est dépourvu de solution d'ammoniaque.

7. Bain selon l'une quelconque des revendications précédentes, **caractérisé en ce que** le métal est un élément de la colonne IIB.

8. Bain selon la revendication 7, **caractérisé en ce que** le métal est du zinc.

9. Procédé de dépôt par voie chimique d'une couche (104) à base au moins de métal et de soufre, dans un bain comprenant en solution (50) :
- un sel métallique (10) comportant un métal choisi parmi au moins un des éléments des groupes IIB et IIIA du tableau périodique ; et
- un précurseur de soufre (20) ;
**caractérisé en ce qu'**un composé de type morpholine (40) est prévu en outre dans ledit bain, et **en ce que** le précurseur de soufre (20) est une solution de thio-urée CS(NH₂)₂.

10. Procédé selon la revendication 9, **caractérisé en ce que** la couche (104) est à base de sulfure de métal.

11. Procédé selon la revendication 9, **caractérisé en ce que** la couche (104) est à base d'oxysulfure de métal.

12. Procédé selon l'une quelconque des revendications 9 à 11, **caractérisé en ce que** la température du bain lors du dépôt est comprise entre 40°C et 100°C.

13. Procédé selon l'une quelconque des revendications 9 à 12, dans lequel la couche (104) à base de métal et soufre est déposée sur une couche à propriétés photovoltaïques, ladite couche à propriétés photovoltaïques formant absorbeur de cellule solaire en couches minces.

14. Procédé de dépôt selon la revendication 13 **caractérisé en ce que** l'absorbeur est à base d'un composé chalcopyrite parmi Cu(In, Ga)(S,Se)₂, Cu₂(Zn,Sn)(S,Se)₄ et leurs dérivés.

## Patentansprüche

1. Chemisches Bad zum Ablagern einer Schicht (104) auf der Basis von wenigstens Metall und Schwefel, wobei das Bad in Lösung (50) umfasst:
- ein Metallsalz (10), umfassend ein Metall, gewählt aus wenigstens einem der Elemente der Gruppen IIB und IIIA des Periodensystems; und
- einen Schwefelvorläufer (20);
**dadurch gekennzeichnet, dass** das Bad ferner eine Verbindung vom Morpholintyp (40) umfasst und dass der Schwefelvorläufer (20) eine Lösung von Thioharnstoff CS(NH₂)₂ ist.

2. Bad nach einem der vorhergehenden Ansprüche, **dadurch gekennzeichnet, dass** die Verbindung (40) die chemische Formel C₄H₉NO hat.

3. Bad nach einem der vorhergehenden Ansprüche, **dadurch gekennzeichnet, dass** im Bad eine Konzentration zwischen 0,001 mol/l und 10 mol/l Morpholin (40) vorgesehen ist, bei einer Konzentration zwischen 0,05 mol/l und 1 mol/l der Sulfidverbindung (20).

4. Bad nach Anspruch 3, **dadurch gekennzeichnet, dass** die Lösung, die das Metallsalz (10) umfasst, eine Lösung ist, gewählt aus: Zinksulfat, Zinkacetat und Zinkchlorid mit einer Konzentration zwischen 0,01 mol/l und 1 mol/l.

5. Bad nach einem der Ansprüche 3 und 4, **dadurch gekennzeichnet, dass** es ferner eine Ammoniaklösung (30) mit einer Konzentration von weniger als 10 mol/l umfasst.

6. Bad nach einem der Ansprüche 1 bis 4, **dadurch gekennzeichnet, dass** es frei von Ammoniaklösung ist.

7. Bad nach einem der vorhergehenden Ansprüche, **dadurch gekennzeichnet, dass** das Metall ein Element aus Spalte IIB ist.

8. Bad nach Anspruch 7, **dadurch gekennzeichnet, dass** das Metall Zink ist.

9. Verfahren zur chemischen Ablagerung einer Schicht (104) auf der Basis von wenigstens Metall und Schwefel in einem Bad, das in Lösung (50) umfasst:
- eine Metallschicht (10), die ein Metall umfasst, das aus wenigstens einem der Elemente der Gruppen IIB und IIIA des Periodensystems gewählt ist; und
- eine Schwefelvorstufe (20);
**dadurch gekennzeichnet, dass** in dem Bad ferner eine Verbindung vom MorpholinTyp (40) vorgesehen ist und dass der Schwefelvorläufer (20) eine Lösung von ThioHarnstoff CS(NH₂)₂ ist.

10. Verfahren nach Anspruch 9, **dadurch gekennzeichnet, dass** die Schicht (104) auf Metallsulfid basiert.

11. Verfahren nach Anspruch 9, **dadurch gekennzeichnet, dass** die Schicht (104) auf Metalloxysulfid basiert.

12. Verfahren nach einem der Ansprüche 9 bis 11, **dadurch gekennzeichnet, dass** die Temperatur des Bades während der Ablagerung zwischen 40°C und 100°C liegt.

13. Verfahren nach einem der Ansprüche 9 bis 12, wobei die auf Metall und Schwefel basierende Schicht (104) auf einer Schicht mit photovoltaischen Eigenschaften abgelagert wird, wobei die Schicht mit photovoltaischen Eigenschaften einen Dünnschicht-Solarzellenabsorber bildet.

14. Ablagerungsverfahren nach Anspruch 13, **dadurch gekennzeichnet, dass** der Absorber auf einer Chalkopyritverbindung aus Cu(In, Ga)(S,Se)₂, Cu₂(Zn,Sn)(S,Se)₄ und Derivaten davon basiert.

## Claims

1. Chemical bath for depositing a layer (104) based on at least metal and sulfur, the bath comprising, in solution (50):
- a metal salt (10) comprising a metal selected from among at least one of the elements of groups IIB and IIIA of the periodic table; and
- a sulfur precursor (20);
**characterized in that** the bath further comprises a morpholine compound (40) and **in that** the solution containing the sulfur compound (20) is a solution of thiourea CS(NH2)2.

2. Bath according to any one of the above claims, wherein the compound (40) is of chemical formula C₄H₉NO.

3. Bath according to any one of the above claims, wherein a concentration between 0.001 mol/L and 10 mol/L of morpholine (40) is provided in the bath, for a concentration between 0.05 mol/L and 1 mol/L of sulfur compound (20).

4. Bath according to claim 3, wherein the solution containing the metal salt (10) is a solution selected from among: zinc sulfate, zinc acetate, and zinc chloride, at a concentration between 0.01 mol/L and 1 mol/L.

5. Bath according to any one of claims 3 and 4, further comprising an ammonia solution (30) at a concentration of less than 10 mol/L.

6. Bath according to any one of claims 1 to 4, wherein it contains no ammonia solution.

7. Bath according to any one of the above claims, wherein the metal is an element from column IIB.

8. Bath according to claim 7, wherein the metal is zinc.

9. Method for chemically depositing a layer (104) based on at least metal and sulfur, in a bath comprising, in solution (50):
- a metal salt (10) comprising a metal selected from among at least one of the elements of groups IIB and IIIA of the periodic table; and
- a sulfur precursor (20);
**characterized in that** a morpholine compound (40) is further provided in said bath and **in that** the solution containing the sulfur compound (20) is a solution of thiourea CS(NH2)2.

10. Method according to claim 9, wherein the layer (104) is based on a metal sulfide.

11. Method according to claim 9, wherein the layer (104) is based on a metal oxysulfide.

12. Method according to any one of claims 9 to 11, wherein the bath temperature during deposition is between 40°C and 100°C.

13. Method according to any one of claims 9 to 12, wherein the layer (104) based on metal and sulfur is deposited on a layer having photovoltaic properties, said layer having photovoltaic properties forming the absorber of a thin-film solar cell.

14. Deposition method according to claim 13, wherein the absorber is based on a chalcopyrite compound among Cu(In,Ga)(S,Se)₂, Cu₂(Zn,Sn)(S,Se)₄, and their derivatives.
